(19) Europäisches Patentamt
European Patent Office
Office européen des brevets

(11) **EP 1 569 332 B1**

(12) **FASCICULE DE BREVET EUROPEEN**

(45) Date de publication et mention
de la délivrance du brevet:
**15.09.2010  Bulletin 2010/37**

(51) Int Cl.:
***H03F 3/30*** *(2006.01)*

(21) Numéro de dépôt: **05290377.0**

(22) Date de dépôt: **18.02.2005**

(54) **Circuit d'amplification de puissance et amplificateur operationnel l'incorporant**

Leistungsverstärker und Operationsverstärker, der diesen beinhaltet

Power amplifier and operational amplifier including the same

(84) Etats contractants désignés:
**DE FR GB IT**

(30) Priorité:  **25.02.2004   FR 0401903**

(43) Date de publication de la demande:
**31.08.2005  Bulletin 2005/35**

(73) Titulaire: **STMicroelectronics S.A.**
**92120 Montrouge (FR)**

(72) Inventeurs:
 • **Pujol, Alexandre**
   **38000 Grenoble (FR)**

 • **Morche, Colette**
   **38240 Meylan (FR)**

(74) Mandataire: **Boire, Philippe Maxime Charles**
**Cabinet Plasseraud**
**52 rue de la Victoire**
**75440 Paris Cedex 09 (FR)**

(56) Documents cités:
**US-A- 4 780 689     US-A- 4 833 424**
**US-A- 5 049 653     US-A- 5 179 355**
**US-B1- 6 535 063**

**Description**

La présente invention concerne un circuit d'amplification de puissance et un amplificateur opérationnel incorporant un tel circuit. Le circuit d'amplification de puissance est utilisé dans l'amplificateur opérationnel comme étage de sortie de puissance («output buffer», en anglais).

Une impédance d'entrée élevée, une impédance de sortie faible et des dynamiques importantes de courant de sortie et de tension de sortie sont certaines des caractéristiques recherchées pour un circuit d'amplification de puissance.

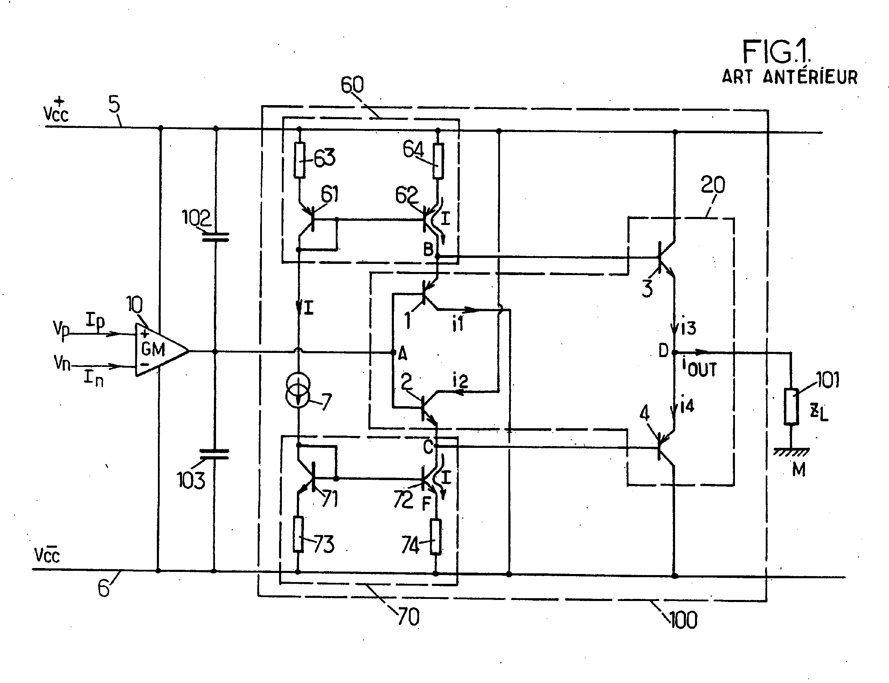

La figure 1 est un diagramme d'un amplificateur opérationnel différentiel, connu dans l'art antérieur. Un tel amplificateur opérationnel comprend deux étages d'amplification cascadés. Un étage d'entrée, désigné par GM, est constitué d'un amplificateur de transconductance différentiel 10, recevant sur deux entrées positive et négative des courants respectifs Ip et In, correspondant à des potentiels électriques d'entrée Vp et Vn. L'amplificateur de transconductance 10 est connecté entre deux bornes d'alimentation en tension, respectivement une borne d'alimentation positive 5 et une borne d'alimentation négative 6, référencées par rapport à une borne de masse électrique M. Des potentiels électriques respectifs $V_{cc}^+$ et $V_{cc}^-$ des bornes d'alimentation 5 et 6 peuvent être, par exemple, +2,5 volts et -2,5 volts. Les courants Ip et In sont de l'ordre de quelques microampères, en valeurs absolues. Les potentiels électriques d'entrée Vp et Vn peuvent varier entre $V_{cc}^-$ et $V_{cc}^+$; ils constituent les signaux d'entrée de l'amplificateur opérationnel.

La sortie de l'amplificateur de transconductance 10 constitue la sortie de l'étage d'entrée. Elle est reliée à un noeud A qui constitue une entrée de l'étage de sortie de puissance 100. Des condensateurs 102 et 103 relient le noeud A aux bornes d'alimentation 5 et 6, respectivement. Ils stabilisent le fonctionnement de l'amplificateur opérationnel.

Un noeud D constitue une sortie de l'étage de sortie de puissance 100, et est aussi une sortie de l'amplificateur opérationnel. Une impédance de charge 101 (ou «load» en anglais), de valeur $Z_L$, est connectée entre le noeud D et la borne de masse M. Usuellement, l'impédance de charge 101 est équivalente à une résistance connectée en parallèle avec un condensateur (non représentés). $Z_L$ peut être égale, par exemple, à 100 ohms en module.

Le circuit d'amplification de puissance qui constitue l'étage de sortie de puissance 100 est désigné dans la suite par circuit 100. Il comprend deux modules de circuit 60 et 70. Le module 60 comprend deux transistors bipolaires 61 et 62 de type pnp, de préférence identiques entre eux. Les émetteurs des transistors 61 et 62 sont reliés à la borne d'alimentation 5 par des résistances identiques respectivement 63 et 64, de valeur commune R. R peut être égale, par exemple, à 1 kilo-ohm. Les bases des transistors 61 et 62 sont connectées entre elles, et en outre au collecteur du transistor 61. Dit autrement, le transistor 61 est connecté en diode. Le module 60 ainsi constitué forme une source de courant Widlar à courants sortants, bien connue. Il possède un fonctionnement en miroir de courant : les courants sortant par les collecteurs des transistors 61 et 62 sont égaux entre eux.

Le module 70 est aussi une source de courant Widlar, mais à courants entrants. Il présente une structure duale de celle du module 60. Le module 70 comprend ainsi deux transistors bipolaires 71 et 72 de type npn, de préférence identiques entre eux. Chacun de ces transistors possède un émetteur relié à la borne d'alimentation 6 par une résistance respectivement 73 et 74. Les résistances 73 et 74 ont une même valeur commune, qui peut être aussi la valeur R, mais non nécessairement. Les bases respectives des transistors 71 et 72 sont connectées entre elles, et en outre au collecteur du transistor 71.

Une source de courant 7 est connectée entre les collecteurs des transistors 61 et 71. La borne positive de la source 7 est connectée au collecteur du transistor 71, et la borne négative de la source 7 est connectée au collecteur du transistor 61. L'intensité I d courant délivré par la source 7 peut être, par exemple, de 200 micro-ampères.

Le circuit 100 comprend en outre un module 20, de type «push-pull». Le module 20 comprend deux transistors bipolaires intermédiaires 1 et 2, respectivement pnp et npn. Les transistors 1 et 2 sont de préférence appariés, c'est-à-dire qu'ils présentent des structures identiques mais ont des types de dopages électriques inversés l'un par rapport à l'autre. Les bases des transistors 1 et 2 sont connectées entre elles et au noeud A. Les émetteurs des transistors 1 et 2 sont respectivement connectés aux collecteurs des transistors 62 et 72, respectivement par un noeud B et par un noeud C. Des transistors de sortie 3 et 4, respectivement de type npn et pnp, de préférence appariés, ont leurs bases respectivement connectées aux noeuds B et C. Les émetteurs des transistors 3 et 4 sont connectés entre eux et au noeud D. Les collecteurs des transistors 3 et 4 sont connectés respectivement aux bornes d'alimentation 5 et 6.

Selon la configuration connue du circuit 100, le collecteur du transistor intermédiaire 1 est directement connecté à la borne d'alimentation 6, et le collecteur du transistor intermédiaire 2 est directement connecté à la borne d'alimentation 5.

Lorsque la différence Vp-Vn entre les potentiels électriques d'entrée Vp et Vn est positive et augmente progressivement, le potentiel électrique du noeud A, noté $V_A$, est aussi positif et varie selon une caractéristique d'amplification de l'amplificateur de transconductance 10. Dans la pratique, $V_A$ est égal à une valeur de saturation qui dépend de $V_{cc}^+$. Conformément au fonctionnement connu du module 20, le transistor 1 est alors dans un état bloqué. D'après le fonctionnement en miroir de courant du module 60, un courant égal à I circule entre l'émetteur et le collecteur du transistor 62. Un courant I circule par conséquent du noeud B vers la base du transistor 3. On a alors :

$$i3 = \beta 3 \times I, \tag{1}$$

où i3 est le courant qui traverse le transistor 3, du collecteur vers l'émetteur de celui-ci, et où $\beta 3$ est le gain en courant du transistor 3.

Le courant de sortie du circuit 100, noté $i_{OUT}$, est alors égal à i3-i4, où i4 est le courant qui traverse le transistor 4, de l'émetteur vers le collecteur. Les orientations de i3 et i4 sont indiquées sur la figure 1. i3 et i4 sont positifs. La valeur de $i_{OUT}$ est limitée par la valeur de i3 donnée par la relation (1). Cette valeur est couramment désignée par $I_{SOURCE}$. Elle est atteinte lorsque le potentiel électrique d'entrée Vp est supérieur au potentiel électrique d'entrée Vn, et que la valeur de l'impédance 101 est suffisamment faible.

Symétriquement, lorsque le potentiel électrique d'entrée Vp est inférieur au potentiel électrique d'entrée Vn, le potentiel électrique du noeud A est négatif. Le courant $i_{OUT}$ est alors négatif et limité, en valeur absolue, par la valeur de i4 donnée par la relation (2) :

$$i4 = \beta 4 \times I, \tag{2}$$

où $\beta 4$ est le gain en courant du transistor 4. Cette valeur est couramment désignée par $I_{SINK}$. $I_{SINK}$ ainsi définie est une valeur positive.

Lorsque le potentiel électrique $V_A$ atteint une valeur suffisamment élevée, le transistor 62 est dans un état saturé. La valeur maximale que peut atteindre le potentiel électrique $V_D$ sur le noeud D est alors $V_{cc}^+ - V_{oh}$, avec :

$$V_{oh} = U_{BE}(3) + U_{EC\,sat}(62) + R \times I, \tag{3}$$

où $U_{BE}(3)$ est la différence entre les potentiels électriques de la base et de l'émetteur du transistor 3, et où $U_{EC\,sat}(62)$ est la différence entre les potentiels électriques de l'émetteur et du collecteur du transistor 62 à l'état de saturation. $V_{oh}$ est appelée tension de déchet, elle peut atteindre 1 volt. Dans la suite, le potentiel $V_D$ est appelé potentiel électrique de sortie du circuit 100.

Une tension de déchet $V_{ol}$, analogue à $V_{oh}$, limite la valeur que peut prendre le potentiel $V_D$ lorsque Vp-Vn est négatif. La valeur minimale de $V_D$ est alors $V_{cc}^- + V_{ol}$. La tension $V_{ol}$ a pour expression :

$$V_{ol} = U_{EB}(4) + U_{CE\,sat}(72) + R \times I, \tag{4}$$

où $U_{EB}(4)$ est la différence entre les potentiels électriques de l'émetteur et de la base du transistor 4, et où $U_{CE\,sat}(72)$ est la différence entre les potentiels électriques du collecteur et de l'émetteur du transistor 72 à l'état de saturation. $V_{ol}$ peut aussi atteindre 1 volt.

Par ailleurs, les émetteurs et les bases respectives des transistors 1 à 4 forment une boucle fermée. La différence entre les potentiels électriques $V_A$ et $V_D$ est donc donnée par la relation double suivante :

$$V_A - V_D = U_{BE}(1) + U_{BE}(3) = U_{BE}(2) + U_{BE}(4), \tag{5}$$

où $U_{BE}(j)$ désigne la tension électrique entre la base et l'émetteur du transistor j, pour j=1, 2, 3 ou 4.

A l'état de repos du circuit 100, c'est-à-dire lorsque Vp=Vn, aucun courant ne sort du noeud D en direction de l'impédance 101 ($I_{OUT}$ = 0), et les potentiels électriques des noeuds A et D sont égaux entre eux. Les courants circulant respectivement entre le noeud B et la base du transistor 3, et entre le noeud C et la base du transistor 4 sont très faibles par rapport au courant I. Un courant i1 égal à I circule alors dans le transistor 1, de l'émetteur vers le collecteur du transistor 1. De même un courant i2 égal à I circule dans le transistor 2, du collecteur vers l'émetteur du transistor 2. Il résulte alors de la relation (5) que i3=i4=n x I, où n est le rapport entre les surfaces respectives des émetteurs des transistors 3 et 2, ou des transistors 4 et 1 :

$$n = \frac{\text{surface de l'émetteur du transistor 3}}{\text{surface de l'émetteur du transistor 2}} = \frac{\text{surface de l'émetteur du transistor 4}}{\text{surface de l'émetteur du transistor 1}} \quad (6)$$

Par exemple, n peut être compris entre 1 et 10.

A l'état de repos du circuit 100, le courant total consommé par le circuit 100, noté $I_{CONS}$, est le courant qui circule entre les bornes d'alimentation 5 et 6. Il est égal à la somme des courants circulant respectivement dans les résistances 63 et 64, de i2 et de i3. On obtient :

$$I_{CONS} = (3 + n) \times I . \quad\quad\quad (7)$$

On cherche à réduire cette valeur du courant total consommé par un circuit d'amplification de puissance à l'état de repos.

Un autre example pour un amplificateur de puissance qui a une pente du signal de sortie élevée est décrit dans US-A-5049653 (Shilh Steven, 1991).

Un but de la présente invention consiste ainsi à proposer un nouveau circuit d'amplification de puissance qui présente une consommation de courant réduite à l'état de repos, pour des valeurs de $I_{SOURCE}$ et $I_{SINK}$ identiques.

L'invention propose donc un circuit d'amplification de puissance qui comprend :

- une entrée et une sortie ;
- un premier module de circuit comprenant un premier et un deuxième transistors d'un même premier type et ayant chacun une première et une seconde électrodes principales et une électrode de commande, lesdites premières électrodes principales desdits premier et deuxième transistors étant respectivement reliées à une première borne d'alimentation en tension par des première et deuxième résistances sensiblement identiques, les électrodes de commande respectives desdits premier et deuxième transistors étant connectées entre elles, l'électrode de commande dudit premier transistor étant en outre connectée à la seconde électrode principale dudit premier transistor ;
- un deuxième module de circuit comprenant un troisième et un quatrième transistors d'un même second type opposé au premier type et ayant chacun une première et une seconde électrodes principales et une électrode de commande, lesdites premières électrodes principales desdits troisième et quatrième transistors étant respectivement reliées à une seconde borne d'alimentation en tension par des troisième et quatrième résistances sensiblement identiques, les électrodes de commande respectives desdits troisième et quatrième transistors étant connectées entre elles, l'électrode de commande dudit troisième transistor étant en outre connectée à la seconde électrode principale dudit troisième transistor ;
- une source de courant connectée aux dites secondes électrodes principales des premier et troisième transistors ;
- un module push-pull comprenant :

    . un premier et un second transistors intermédiaires, respectivement des premier et second types et ayant chacun une première et une seconde électrodes principales et une électrode de commande, les deux électrodes de commande des premier et second transistors intermédiaires étant connectées entre elles et à l'entrée du circuit, les premières électrodes principales des premier et second transistors intermédiaires étant respectivement connectées aux secondes électrodes principales respectives desdits deuxième et quatrième transistors, respectivement par un premier et un second noeuds;

    . un premier et un second transistors de sortie, respectivement des second et premier types et ayant chacun une première et une seconde électrodes principales et une électrode de commande, les électrodes de commande desdits premier et second transistors de sortie étant respectivement connectées auxdits premier et second noeuds, lesdites premières électrodes principales des premier et second transistors de sortie étant connectées entre elles et à la sortie du circuit, lesdites secondes électrodes principales des premier et second transistors de sortie étant reliées respectivement aux dites première et seconde bornes d'alimentation en tension.

Le circuit d'amplification de puissance comprend en outre :

- un troisième module de circuit ayant une première et une seconde entrées connectées respectivement à la seconde électrode principale dudit premier transistor intermédiaire et à la première électrode principale dudit deuxième transistor, et agencé de telle sorte qu'un courant électrique circulant par ladite seconde entrée est identique à un courant électrique circulant par ladite première entrée, et
- un quatrième module de circuit ayant une première et une seconde sorties connectées respectivement à la seconde électrode principale dudit second transistor intermédiaire et à la première électrode principale dudit quatrième transistor, et agencé de telle sorte qu'un courant électrique circulant par ladite seconde sortie est identique à un courant électrique circulant par ladite première sortie.

Ainsi, une partie du courant circulant dans la seconde résistance du premier module de circuit est envoyée dans ledit troisième module de circuit, qui fonctionne en miroir de courant. Le courant qui traverse le deuxième transistor du premier module de circuit est alors diminué, de même que le courant qui traverse ledit premier transistor intermédiaire. Cette diminution provoque une diminution du courant qui circule entre les électrodes principales du premier transistor de sortie. Il en résulte une diminution du courant total consommé par le circuit, entre les deux bornes d'alimentation en tension.

Symétriquement, une partie du courant circulant dans ladite quatrième résistance du deuxième module de circuit provient dudit quatrième module de circuit fonctionnant en miroir de courant. Il en résulte des diminutions des courants circulant entre les électrodes principales dudit quatrième transistor et dudit second transistor intermédiaire, et par conséquent aussi une diminution du courant circulant entre les électrodes principales du second transistor de sortie.

Par ailleurs, la valeur absolue maximale du courant de sortie d'un tel circuit est identique à celle d'un circuit conforme à la figure 1.

En outre, un tel circuit présente des tensions de déchet sensiblement égales à celles d'un circuit conforme à la figure 1.

Les dynamiques du courant de sortie et du potentiel électrique de sortie du circuit ne sont donc pas réduites.

Enfin, ce circuit est particulièrement simple et robuste. Il est donc peu onéreux et sa durée de fonctionnement est importante.

Dans le mode de réalisation préféré, ledit troisième module de circuit comprend un cinquième et un sixième transistors dudit second type, ayant chacun une première et une seconde électrodes principales et une électrode de commande. Lesdites premières électrodes principales desdits cinquième et sixième transistors sont respectivement reliées à la seconde borne d'alimentation en tension par des cinquième et sixième résistances sensiblement identiques. Les électrodes de commande respectives desdits cinquième et sixième transistors sont connectées entre elles, et l'électrode de commande dudit cinquième transistor est en outre connectée à la seconde électrode principale dudit cinquième transistor. Lesdites secondes électrodes principales desdits cinquième et sixième transistors comprennent respectivement lesdites première et seconde entrées dudit troisième module de circuit.

De même, ledit quatrième module de circuit peut comprendre un septième et un huitième transistors dudit premier type, ayant chacun une première et une seconde électrodes principales et une électrode de commande. Lesdites premières électrodes principales desdits septième et huitième transistors sont respectivement reliées à la première borne d'alimentation en tension par des septième et huitième résistances sensiblement identiques. Les électrodes de commande respectives desdits septième et huitième transistors sont connectées entre elles, et l'électrode de commande dudit septième transistor est en outre connectée à la seconde électrode principale dudit septième transistor. Lesdites secondes électrodes principales desdits septième et huitième transistors comprennent respectivement lesdites première et seconde sorties dudit quatrième module de circuit.

Avantageusement, certains au moins des transistors du circuit amplificateur de puissance sont des transistors bipolaires.

L'invention concerne aussi un amplificateur opérationnel comprenant un circuit d'amplification de puissance tel que décrit précédemment, ledit circuit constituant un étage de sortie de puissance dudit amplificateur opérationnel. Un tel amplificateur opérationnel présente une consommation totale de courant réduite et peut délivrer un courant de sortie identique.

D'autres particularités et avantages de la présente invention apparaîtront dans la description ci-après d'un exemple de réalisation non limitatif, en référence aux dessins annexés, dans lesquels :

- la figure 1, déjà décrite, est un diagramme électrique d'un amplificateur opérationnel connu ;

- la figure 2 est un diagramme électrique d'un amplificateur opérationnel comprenant un circuit d'amplification de puissance selon l'invention ;

- les figures 3a et 3b sont des diagrammes électriques de deux modules de circuit pouvant être utilisés dans un amplificateur opérationnel conforme à la figure 2 ;

- les figures 4a et 4b représentent des variations du courant de sortie maximal, en valeur absolue, pour deux circuits respectivement conformes à la figure 1 et à la figure 2 ; et

- la figure 5 illustre une configuration préférée de transistors pouvant être utilisée pour un module de circuit conforme à la figure 3b.

Des références identiques utilisées sur plusieurs figures correspondent à des éléments identiques, ou qui remplissent des fonctions analogues.

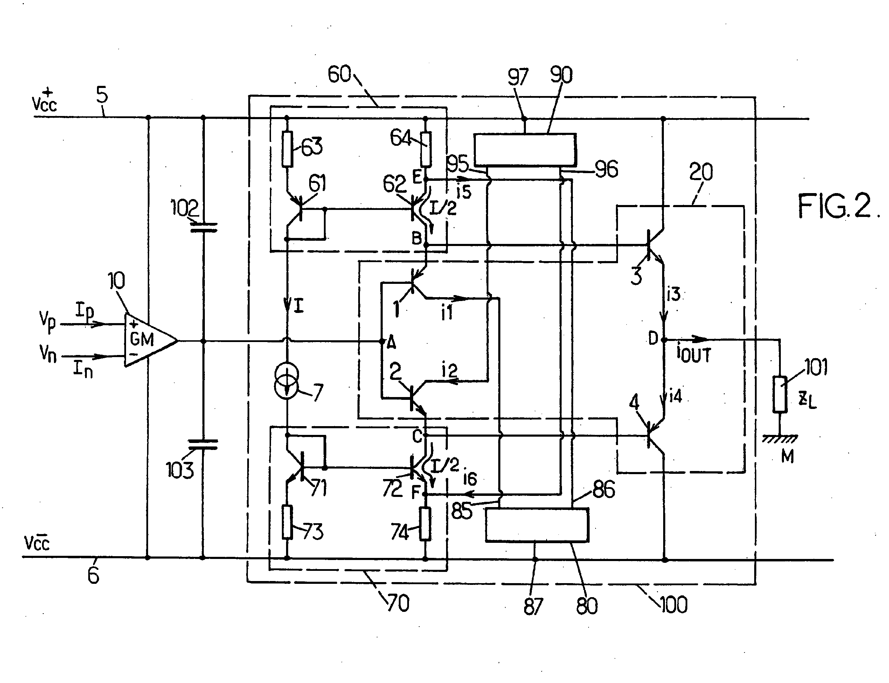

Un amplificateur opérationnel conforme à la figure 2 comprend des composants identiques à ceux d'un amplificateur opérationnel conforme à la figure 1, agencés de la même façon. La description de ces composants communs n'est pas reprise ici : on se reportera à la description de la figure 1 ci-dessus.

Conformément au diagramme de la figure 2, au sein du circuit 100 selon l'invention, la connexion entre le collecteur du transistor intermédiaire 1 et la borne d'alimentation en tension 6, ainsi que la connexion entre le collecteur du transistor intermédiaire 2 et la borne d'alimentation en tension 5, sont supprimées. Elles sont remplacées par deux modules de circuit supplémentaires 80 et 90.

Le module 80 est connecté à la borne d'alimentation en tension 6 par un noeud 87. On rappelle que le potentiel électrique de la borne d'alimentation en tension 6 est inférieur à celui de la borne d'alimentation en tension 5. Le module 80 possède une entrée 85 connectée au collecteur du transistor intermédiaire 1, et une entrée 86 connectée à l'émetteur du transistor 62 par un noeud E. Le module 80 est agencé de telle sorte qu'un courant électrique i5 circulant entre le noeud E et l'entrée 86 est identique à un courant électrique i1 sortant du collecteur du transistor 1. Autrement dit, i5 = i1 : le module 80 possède un fonctionnement en miroir de courant. Les orientations adoptées pour les courants i1 et i5 sont indiquées sur la figure 2.

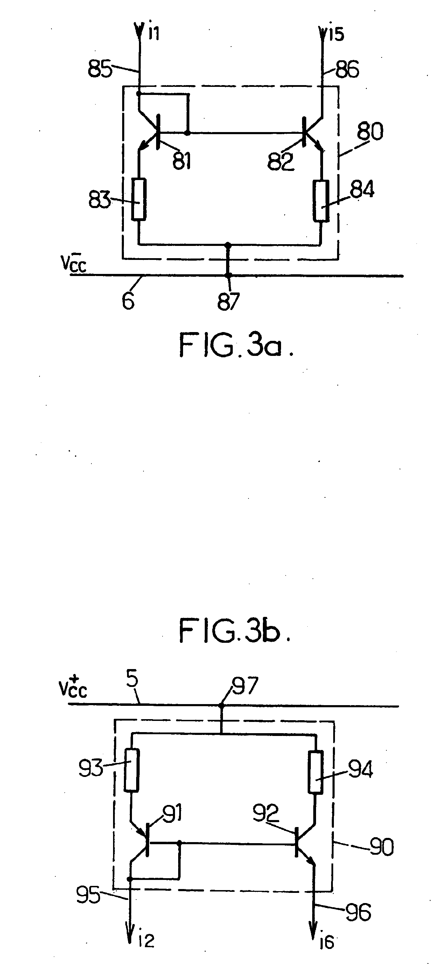

La figure 3a est un diagramme électrique d'un module de circuit qui peut être utilisé pour le module 80. Ce module de circuit est de type source de courant Widlar à courants entrants. Il comprend deux transistors bipolaires 81 et 82 de type npn. Les émetteurs des transistors 81 et 82 sont respectivement reliés à la borne d'alimentation en tension 6 par des résistances 83 et 84 sensiblement identiques. Les bases respectives des transistors 81 et 82 sont connectées entre elles, et en outre au collecteur du transistor 81. Les transistors 81 et 82 sont de préférence identiques entre eux. Les résistances 83 et 84 peuvent avoir une valeur de 1 kilo-ohm, par exemple.

Le module 90 est connecté à la borne d'alimentation en tension 5 par un noeud 97. Le module 90 possède une sortie 95 connectée au collecteur du transistor intermédiaire 2, et une sortie 96 connectée à l'émetteur du transistor 72 par un noeud F. Le module 90 est agencé de telle sorte qu'un courant électrique i6 circulant entre la sortie 96 et le noeud F est identique à un courant électrique i2 entrant par le collecteur du transistor 2. Autrement dit, i6 = i2 : le module 90 possède aussi un fonctionnement en miroir de courant. Les orientations adoptées pour les courants i2 et i6 sont indiquées sur la figure 2.

La figure 3b est un diagramme électrique d'un autre module de circuit, qui peut être utilisé pour le module 90. Cet autre module de circuit est de type source de courant Widlar à courants sortants. Les transistors bipolaires 91 et 92 sont de type pnp, et sont de préférence identiques entre eux. Les émetteurs des transistors 91 et 92 sont respectivement reliés à la borne d'alimentation en tension 5 par des résistances 93 et 94 sensiblement identiques. Les bases respectives des transistors 91 et 92 sont connectées entre elles, et en outre au collecteur du transistor 91. Les résistances 93 et 94 peuvent aussi avoir une valeur de 1 kilo-ohm, par exemple.

L'ajout des noeuds E et F respectivement dans les modules 60 et 70 a pour conséquence que ces modules ne fonctionnent plus en miroirs de courant. A l'état de repos du circuit 100, le courant qui circule entre le noeud B et la base du transistor 3 est négligeable par rapport au courant entrant dans l'émetteur du transistor 1. Le courant qui circule dans la résistance 64 est alors 2 x i5. La relation des tensions électriques dans la boucle formée par la résistance 63, les transistors 61 et 62, et la résistance 64 est par conséquent :

$$R \times I + U_{EB}(61) = R \times 2 \times i5 + U_{EB}(62) \,, \qquad (8)$$

où $U_{EB}(61)$ et $U_{EB}(62)$ désignent la différence entre les potentiels électriques de l'émetteur et de la base, respectivement pour les transistors 61 et 62. Par conséquent:

$$i5 = \frac{I}{2} + \frac{\Delta U_{EB}}{2 \times R} \,, \text{ où } \Delta U_{EB} = U_{EB}(61) - U_{EB}(62) \,. \qquad (9)$$

En tenant compte des valeurs numériques de ces grandeurs, on obtient que :

$$\left|\frac{\Delta U_{EB}}{2 \times R}\right| << \frac{I}{2} , \tag{10}$$

où | | désigne la valeur absolue. Par conséquent, i5 est approximativement égal à I/2. Il s'en suit que le courant qui traverse le transistor 62 à l'état de repos (i.e. lorsque Vp = Vn) est aussi approximativement égal à I/2. Le courant qui traverse le transistor 62 est donc approximativement égal à la moitié du courant correspondant dans le cas d'un circuit conforme à la figure 1.

Un raisonnement analogue à celui qui vient d'être présenté, appliqué au module 70 et au transistor 2, aboutit à i2 = i6 ≈ I/2 .

Le courant total $I_{CONS}$ consommé dans un circuit 100 conforme à la figure 2, à l'état de repos (i.e. lorsque Vp = Vn), entre les bornes d'alimentation en tension 5 et 6, est la somme :

-   du courant circulant dans la résistance 63, c'est-à-dire 1,
-   du courant circulant dans la résistance 64,
-   du courant entrant dans le module 90 à partir du noeud 97, et
-   du courant circulant entre le collecteur et l'émetteur du transistor 3.

D'après le noeud E, le courant qui circule dans la résistance 64 est égal à 2 x I/2, approximativement, c'est-à-dire égal à I. D'après les valeurs déterminées ci-dessus pour les courants i2 et i6, le courant rentrant dans le module 90 à partir du noeud 97 est i2 + i6 ≈ 2 x I/2 ≈ I. Par ailleurs, d'après la relation (5) encore valable pour un circuit 100 conforme à la figure 2, et compte tenu qu'à l'état de repos $V_A = V_D$, il résulte que $U_{BE}(3) = -U_{BE}(1)$, et donc que i3 = n x I/2. Par conséquent :

$$I_{CONS} = 3 \times I + n \times I/2 = (3 + n/2) \times I . \tag{11}$$

n désigne encore le rapport entre les surfaces des émetteurs des transistors 3 et 2, qui est égal au rapport entre les surfaces des émetteurs des transistors 4 et 1. A valeur de n égale, la consommation totale de courant d'un circuit 100 conforme à la figure 2 est donc inférieure de n x I/2 par rapport à celle d'un circuit 100 conforme à la figure 1, d'après une comparaison entre les relations (7) et (11).

Le tableau 1 ci-dessous indique les valeurs de $I_{CONS}$ pour différentes valeurs de n, pour deux circuits respectivement conformes à la figure 1 et à la figure 2. Le tableau 1 indique aussi le gain relatif de consommation totale en courant, pour un circuit conforme à la figure 2 par rapport à un circuit conforme à la figure 1 :

<div align="center">Tableau 1</div>

| n | $I_{CONS}$ (figure 1) | $I_{CONS}$ (figure 2) | Gain $= \dfrac{\Delta I_{CONS}}{I_{CONS} (fig.1)}$ |
|---|---|---|---|
| 1 | 4 x I | 3,5 x I | 13% |
| 2 | 5 x I | 4 x I | 20% |
| 5 | 8 x I | 5,5 x I | 31% |
| 10 | 13 x I | 8 x I | 38% |

Les expressions de $I_{SOURCE}$ et de $I_{SINK}$ données par les relations (1) et (2) sont encore valables pour un circuit 100 conforme à la figure 2. La valeur absolue maximale du courant $i_{OUT}$ est donc la même pour deux circuits 100 respectivement conformes aux figures 1 et 2.

De même les relations (3) et (4) donnant les expressions des tensions de déchet $V_{oh}$ et $V_{ol}$ sont encore valables pour un circuit 100 conforme à la figure 2.

On compare maintenant les caractéristiques d'un circuit 100 conforme à la figure 2 à celles d'un circuit 100 conforme à la figure 1. Pour effectuer cette comparaison, le courant I de la source 7 du circuit 100 conforme à la figure 2 est ajusté de sorte que les deux circuits présentent des valeurs identiques de courant total consommé $I_{CONS}$. Pour cela, le courant I pour le circuit 100 conforme à la figure 2 est augmenté de façon à compenser le gain indiqué dans la dernière colonne du tableau 1, par exemple pour n=10. Tous les composants présents dans chacun des deux circuits considérés, qui correspondent à des mêmes références sur les figures 1 et 2, ont des valeurs identiques en dehors de la valeur l pour la source de courant 7.

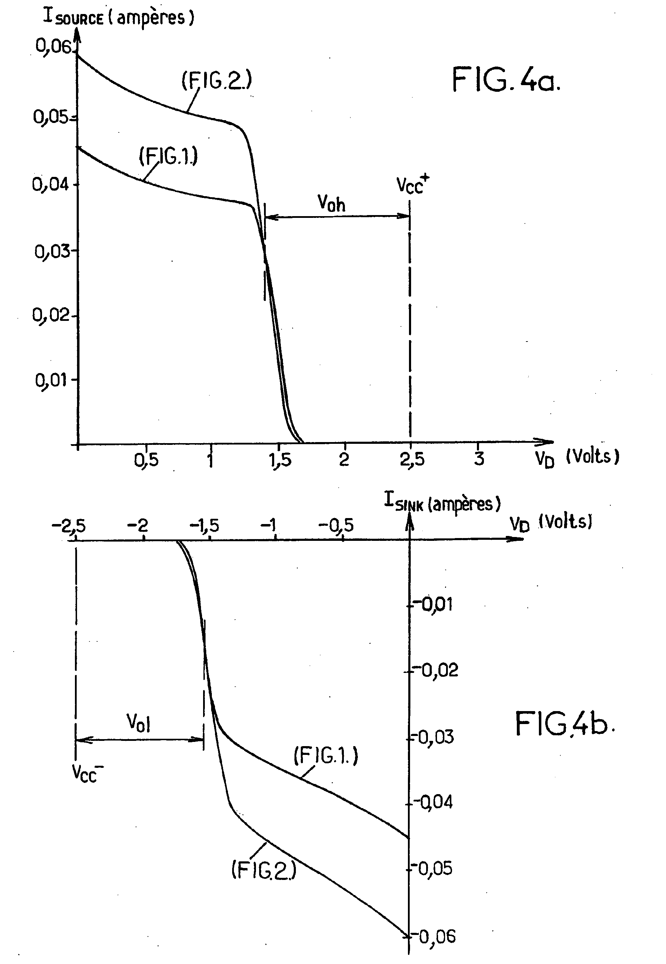

La figure 4a illustre les variations de $I_{SOURCE}$ en fonction du potentiel électrique du noeud D lorsque la différence Vp-Vn est positive, pour chacun des deux circuits considérés. Il s'agit donc de courbes caractéristiques de sortie, en coordonnées tension-courant, respectivement pour un circuit 100 conforme à la figure 1 et pour un circuit 100 conforme à la figure 2. Chacune de ces courbes caractéristiques est du type générateur de courant, qui comprend un plateau jusqu'à une valeur maximale du potentiel électrique du noeud D, fixée par la tension de déchet $V_{oh}$. La valeur de $I_{SOURCE}$ au niveau de ce plateau est environ 0,038 ampère pour un circuit 100 conforme à la figure 1, et environ 0,051 ampère pour un circuit 100 conforme à la figure 2. L'augmentation obtenue pour la valeur de $I_{SOURCE}$ est donc de 34% environ. La pente de chaque courbe au niveau du plateau est liée à une variation résiduelle des potentiels électriques des électrodes des transistors 1 et 62.

Ces courbes montrent en outre que la tension de déchet $V_{oh}$ possède sensiblement la même valeur pour les deux circuits conformes respectivement à la figure 1 et à la figure 2. En effet, les plateaux correspondant à chacun des deux circuits présentent des longueurs identiques.

La figure 4b est analogue à la figure 4a, lorsque Vp-Vn est négatif. Elle indique les valeurs minimales du courant $i_{OUT}$ (ces valeurs minimales étant négatives). Elle correspond donc à $-I_{SINK}$.

De préférence, lorsque l'un des modules de circuit 80 ou 90 est réalisé sous forme d'un circuit intégré à la surface d'un substrat S, l'un au moins des transistors de ce module a une configuration verticale. Selon une telle configuration, une direction principale de conduction du transistor est sensiblement perpendiculaire à une surface du substrat.

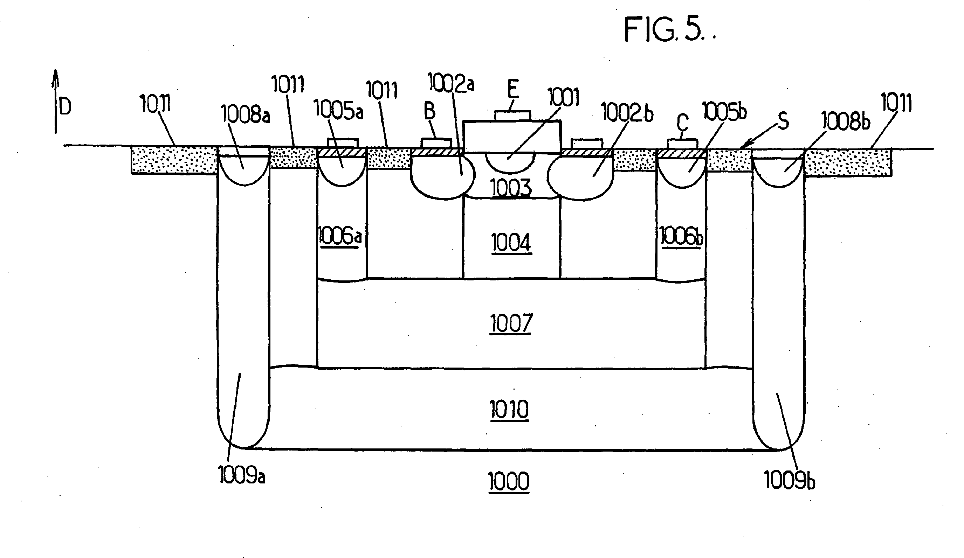

La figure 5 représente un transistor bipolaire de type pnp ayant une configuration verticale. La direction D, orientée vers le haut de la figure, est sensiblement perpendiculaire à une surface S d'un substrat 1000. Le substrat 1000 est de type p. Plusieurs zones dopées sont superposées dans le substrat 1000 sous la surface S, par rapport à la direction D. Une zone 1001 de type P+ constitue la zone d'émetteur du transistor, une zone 1003 de type N constitue le canal du transistor, une zone intermédiaire 1004 est de type P, et une zone 1007, aussi de type P et dite zone enterrée, constitue le collecteur du transistor. Un courant circulant de l'émetteur vers le collecteur du transistor traverse les zones 1001, 1003, 1004 et 1007 : il circule donc parallèlement à la direction D. Enfin, une zone profonde 1010 est dopée N.

Une zone de contact d'émetteur E est disposée au dessus de la zone 1001, en liaison électrique avec celle-ci.

La zone 1003 est contiguë avec des zones de contact de base B référencées 1002a et 1002b. Les zones de contact 1002a et 1002b sont disposées au niveau de la surface S, de chaque côté de la zone 1003. Elles sont dopées N+.

La zone 1007 est reliée à des zones contact de collecteur 1005a et 1005b par des zones de connexion électrique 1006a et 1006b. Les zones de contact 1005a et 1005b sont disposées au niveau de la surface S et sont dopées P+. Les zones de connexion électrique 1006a et 1006b sont formées par des puits P.

Enfin, la zone profonde 1010 sépare le transistor du reste du volume du substrat 1000. Elle est reliée à des zones de contact 1008a et 1008b disposées au niveau de la surface S, par des zones de connexion électrique 1009a et 1009b. Les zones de contact 1008a et 1008b sont dopées N+ et les zones de connexion électrique 1009a et 1009b sont formées par des puits N. La zone 1010 peut ainsi être portée à un potentiel électrique déterminé.

Des zones d'isolation électrique 1011, par exemple en silice, séparent les différentes zones de contact au niveau de la surface S.

Un transistor ayant une telle configuration occupe une partie réduite de la surface S du substrat 1000 : il peut être réalisé avec un niveau d'intégration particulièrement élevé. Une dimension du transistor parallèlement à la surface S du substrat 1000 peut être, par exemple, 0,25 micromètre environ, mesurée entre les bords extérieurs de deux zones d'isolation 1011 extrêmes et opposées du transistor. Le module de circuit qui comprend un tel transistor est alors particulièrement compact.

La configuration d'un transistor illustrée par la figure 5 est donnée à titre d'exemple. D'autres configurations équivalentes peuvent être utilisées, qui procurent des possibilités d'intégration équivalentes.

Les modules de circuit correspondant aux figures 3a et 3b sont aussi donnés à titre d'exemples. Il est entendu que d'autres circuits fonctionnant en miroirs de courant et connus de l'Homme du métier peuvent être utilisés pour les modules 80 et 90.

Enfin, il est aussi entendu qu'un circuit conforme au principe de l'invention peut être obtenu en utilisant des transistors à effet de champ, notamment réalisés selon la technologie MOS (pour «Metal Oxide Semiconductor» en anglais). Le remplacement de chaque transistor bipolaire décrit plus haut par un transistor à effet de champ peut être effectué selon les règles de correspondance connues entre les différents types de transistors bipolaires et les différents types de transistors à effet de champ.

**Revendications**

1. Circuit d'amplification de puissance (100) comprenant :

- une entrée (A) et une sortie (D) ;
- un premier module de circuit (60) comprenant un premier (61) et un deuxième (62) transistors d'un même premier type et ayant chacun une première et une seconde électrodes principales et une électrode de commande, lesdites premières électrodes principales desdits premier et deuxième transistors étant respectivement reliées à une première borne d'alimentation en tension (5) par des première (63) et deuxième (64) résistances sensiblement identiques, les électrodes de commande respectives desdits premier (61) et deuxième (62) transistors étant connectées entre elles, l'électrode de commande dudit premier transistor étant en outre connectée à la seconde électrode principale dudit premier transistor ;
- un deuxième module de circuit (70) comprenant un troisième (71) et un quatrième (72) transistors d'un même second type opposé au premier type et ayant chacun une première et une seconde électrodes principales et une électrode de commande, lesdites premières électrodes principales desdits troisième et quatrième transistors étant respectivement reliées à une seconde borne d'alimentation en tension (6) par des troisième (73) et quatrième (74) résistances sensiblement identiques, les électrodes de commande respectives desdits troisième (71) et quatrième (72) transistors étant connectées entre elles, l'électrode de commande dudit troisième transistor étant en outre connectée à la seconde électrode principale dudit troisième transistor ;
- une source de courant (7) connectée aux dites secondes électrodes principales des premier (61) et troisième (71) transistors ;
- un module push-pull (20) comprenant :

un premier (1) et un second (2) transistors intermédiaires, respectivement des premier et second types et ayant chacun une première et une seconde électrodes principales et une électrode de commande, les deux électrodes de commande des premier (1) et second (2) transistors intermédiaires étant connectées entre elles et à l'entrée (A) du circuit (100), les premières électrodes principales des premier (1) et second (2) transistors intermédiaires étant respectivement connectées aux secondes électrodes principales respectives desdits deuxième (62) et quatrième (72) transistors, respectivement par un premier (B) et un second (C) noeuds ;
un premier (3) et un second (4) transistors de sortie, respectivement des second et premier types et ayant chacun une première et une seconde électrodes principales et une électrode de commande, les électrodes de commande desdits premier et second transistors de sortie étant respectivement connectées auxdits premier (B) et second (C) noeuds, lesdites premières électrodes principales des premier (3) et second (4) transistors de sortie étant connectées entre elles et à la sortie (D) du circuit (100), lesdites secondes électrodes principales des premier (3) et second (4) transistors de sortie étant reliées respectivement aux dites première (5) et seconde (6) bornes d'alimentation en tension,

**caractérisé en ce que** ledit circuit (100) comprend en outre :

- un troisième module de circuit (80) ayant une première (85) et une seconde (86) entrées connectées respectivement à la seconde électrode principale dudit premier transistor intermédiaire (1) et à la première électrode principale dudit deuxième transistor (62), et agencé de telle sorte qu'un courant électrique circulant par ladite seconde entrée (86) est identique à un courant électrique circulant par ladite première entrée (85), et
- un quatrième module de circuit (90) ayant une première (95) et une seconde (96) sorties connectées respectivement à la seconde électrode principale dudit second transistor intermédiaire (2) et à la première électrode principale dudit quatrième transistor (72), et agencé de telle sorte qu'un courant électrique circulant par ladite seconde sortie (96) est identique à un courant électrique circulant par ladite première sortie (95).

2. Circuit selon la revendication 1, dans lequel ledit troisième module de circuit (80) comprend un cinquième (81) et un sixième (82) transistors dudit second type et ayant chacun une première et une seconde électrodes principales et une électrode de commande, lesdites premières électrodes principales desdits cinquième et sixième transistors étant respectivement reliées à la seconde borne d'alimentation en tension (6) par des cinquième (93) et sixième (94) résistances sensiblement identiques, les électrodes de commande respectives desdits cinquième (81) et sixième (82) transistors étant connectées entre elles, l'électrode de commande dudit cinquième transistor étant en outre connectée à la seconde électrode principale dudit cinquième transistor, lesdites secondes électrodes principales desdits cinquième (81) et sixième (82) transistors comprenant respectivement lesdites première (85) et seconde (86) entrées dudit troisième module de circuit (80).

3. Circuit selon la revendication 1 ou 2, dans lequel ledit quatrième module de circuit (90) comprend un septième (91) et un huitième (92) transistors dudit premier type et ayant chacun une première et une seconde électrodes principales et une électrode de commande, lesdites premières électrodes principales desdits septième et huitième transistors étant respectivement reliées à la première borne d'alimentation en tension (5) par des septième (93) et huitième (94) résistances sensiblement identiques, les électrodes de commande respectives desdits septième (91) et huitième (92) transistors étant connectées entre elles, l'électrode de commande dudit septième transistor étant en outre connectée à la seconde électrode principale dudit septième transistor, lesdites secondes électrodes principales desdits septième (91) et huitième (92) transistors comprenant respectivement lesdites première (95) et seconde (96) sorties dudit quatrième module de circuit (90).

4. Circuit selon l'une quelconque des revendications précédentes, dans lequel certains au moins des transistors dudit circuit sont des transistors bipolaires.

5. Circuit selon l'une quelconque des revendications précédentes, dans lequel au moins un transistor desdits troisième (80) ou quatrième (90) modules de circuit a une direction principale de conduction sensiblement perpendiculaire à une surface d'un substrat dudit module de circuit.

6. Amplificateur opérationnel comprenant un circuit d'amplification de puissance selon l'une quelconque des revendications 1 à 5, ledit circuit constituant un étage de sortie de puissance dudit amplificateur opérationnel.

**Claims**

1. Power amplification circuit (100) comprising:

   - an input (A) and an output (D);
   - a first circuit module (60) comprising a first (61) and a second (62) transistor of a same first type and each having a first and a second main electrode and a control electrode, said first main electrodes of said first and second transistors being respectively connected to a first voltage supply terminal (5) via first (63) and second (64) substantially identical resistors, the respective control electrodes of said first (61) and second (62) transistors being connected to each other, the control electrode of said first transistor being also connected to the second main electrode of said first transistor;
   - a second circuit module (70) comprising a third (71) and a fourth (72) transistor of a same second type opposite to the first type and each having a first and a second main electrode and a control electrode, said first main electrodes of said third and fourth transistors being respectively connected to a second voltage supply terminal (6) by third (73) and fourth (74) substantially identical resistors, the respective control electrodes of said third (71) and fourth (72) transistors being connected to each other, the control electrode of said third transistor also being connected to the second main electrode of said third transistor;
   - a current source (7) connected to said second main electrodes of the first (61) and third (71) transistors;
   - a push-pull module (20) comprising:

     a first (1) and a second (2) intermediate transistor, respectively of the first and second types, each having a first and a second main electrode and a control electrode, the two control electrodes of the first (1) and second (2) intermediate transistors being connected to each other and to the input (A) of the circuit (100), the first main electrodes of the first (1) and second (2) intermediate transistors being respectively connected to the respective second main electrodes of said second (62) and fourth (72) transistors, by a first (B) and a second (C) node, respectively;
     a first (3) and a second (4) output transistor, respectively of the second and first types, each having a first and a second main electrode and a control electrode, the control electrodes of said first and second output transistors being respectively connected to said first (B) and second (C) nodes, said first main electrodes of the first (3) and second (4) output transistors being connected to each other and to the output (D) of the circuit (100), said second main electrodes of the first (3) and second (4) output transistors being respectively connected to said first (5) and second (6) voltage supply terminals,

   **characterized in that** said circuit (100) also comprises:

   - a third circuit module (80) having a first (85) and a second (86) input connected respectively to the second main electrode of said first intermediate transistor (1) and to the first main electrode of said second transistor (62), and arranged such that an electric current flowing into said second input (86) is identical to an electric current flowing into said first input (85), and
- a fourth circuit module (90) having a first (95) and a second (96) output respectively connected to the second main electrode of said second intermediate transistor (2) and to the first main electrode of said fourth transistor (72), and arranged such that an electric current flowing from said second output (96) is identical to an electric current flowing from said first output (95).

2. Circuit according to Claim 1, wherein said third circuit module (80) comprises a fifth (81) and a sixth (82) transistor of said second type, each having a first and a second main electrode and a control electrode, said first main electrodes of said fifth and sixth transistors being respectively connected to the second voltage supply terminal (6) via fifth (93) and sixth (94) substantially identical resistors, the respective control electrodes of said fifth (81) and sixth (82) transistors being connected to each other, the control electrode of said fifth transistor also being connected to the second main electrode of said fifth transistor, said second main electrodes of said fifth (81) and sixth (82) transistors respectively comprising said first (85) and second (86) inputs of said third circuit module (80).

3. Circuit according to Claim 1 or 2, wherein said fourth circuit module (90) comprises a seventh (91) and an eighth (92) transistor of said first type, each having a first and a second main electrode and a control electrode, said first main electrodes of said seventh and eighth transistors being respectively connected to the first voltage supply terminal (5) via seventh (93) and eighth (94) substantially identical resistors, the respective control electrodes of said seventh (91) and eighth (92) transistors being connected to each other, the control electrode of said seventh transistor also being connected to the second main electrode of said seventh transistor, said second main electrodes of said seventh (91) and eighth (92) transistors respectively comprising said first (95) and second (96) outputs of said fourth circuit module (90).

4. Circuit according to any one of the preceding claims, wherein at least some of the transistors of said circuit are bipolar transistors.

5. Circuit according to any one of the preceding claims, wherein at least one transistor of said third (80) or fourth (90) circuit modules has a main conduction direction substantially perpendicular to a surface of a substrate of said circuit module.

6. Operational amplifier comprising a power amplification circuit according to any one of Claims 1 to 5, said circuit forming a power output stage of said operational amplifier.

**Patentansprüche**

1. Leistungsverstärkungsschaltung (100) mit:

einem Eingang (A) und einem Ausgang (D);
einem ersten Schaltungsmodul (60), das einen ersten (61) und einen zweiten (62) Transistor eines gleichen ersten Typs aufweist, und jeder eine erste und eine zweite Hauptelektrode und eine Steuerelektrode aufweist, wobei die ersten Hauptelektroden des ersten und zweiten Transistors jeweils mit einer ersten Anschlussklemmenspannung (5) über einen ersten (63) und einen im Wesentlichen identischen zweiten (64) Widerstand verbunden sind, wobei die jeweiligen Steuerelektroden des ersten (61) und zweiten (62) Transistors miteinander verbunden sind, wobei die Steuerelektrode des ersten Transistors ferner mit der zweiten Hauptelektrode des ersten Transistors verbunden ist;
einem zweiten Schaltungsmodul (70), das einen dritten (71) und einen vierten (72) Transistor eines gleichen zweiten Typs aufweist, der dem ersten Typ entgegengesetzt ist, und jeder eine erste und eine zweite Hauptelektrode und eine Steuerelektrode aufweist, wobei die ersten Hauptelektroden des dritten und vierten Transistors jeweils mit einer zweiten Anschlussklemmenspannung (6) über einen dritten (73) und einen im Wesentlichen identischen vierten (74) Widerstand verbunden sind, wobei die jeweiligen Steuerelektroden des dritten (71) und vierten (72) Transistors miteinander verbunden sind, wobei die Steuerelektrode des dritten Transistors ferner mit der zweiten Hauptelektrode des dritten Transistors verbunden ist;
einer Stromquelle (7), die mit den zweiten Hauptelektroden des ersten (61) und dritten (71) Transistors verbunden ist;
einem Push-Pull-Modul (20) mit:

einem ersten (1) und einem zweiten (2) Zwischentransistor jeweils eines ersten und eines zweiten Typs, wobei jeder eine erste und eine zweite Hauptelektrode und eine Steuerelektrode aufweist, wobei die zwei Steuerelektroden des ersten (1) und zweiten (2) Zwischentransistors miteinander und mit dem Eingang (A) der Schaltung (100) verbunden sind, wobei die ersten Hauptelektroden des ersten (1) und zweiten (2) Zwischentransistors jeweils mit den jeweiligen zweiten Hauptelektroden des zweiten (62) und vierten (72) Transistors jeweils über einen ersten (B) und einen zweiten (C) Knoten verbunden sind;

einem ersten (3) und einem zweiten (4) Ausgangstransistor jeweils eines zweiten und eines ersten Typs, wobei jeder eine erste und eine zweite Hauptelektrode und eine Steuerelektrode aufweist, wobei die Steuerelektroden des ersten und zweiten Ausgangstransistors jeweils mit dem ersten (B) und zweiten (C) Knoten verbunden sind, wobei die ersten Hauptelektroden des ersten (3) und zweiten (4) Ausgangstransistors miteinander und mit dem Ausgang (D) der Schaltung (100) verbunden sind, wobei die zweiten Hauptelektroden des ersten (3) und zweiten (4) Ausgangstransistors jeweils mit der ersten (5) und zweiten (6) Anschlussklemmenspannung verbunden sind,

**dadurch gekennzeichnet, dass** die Schaltung (100) ferner Folgendes aufweist:

ein drittes Schaltungsmodul (80), das einen ersten (85) und einen zweiten (86) Eingang aufweist, die jeweils mit der zweiten Hauptelektrode des ersten Zwischentransistors (1) und mit der ersten Hauptelektrode des zweiten Transistors (62) verbunden sind, und in einer solchen Art und Weise aufgebaut ist, dass ein über den zweiten Eingang (86) umlaufender elektrischer Strom zu einem über den ersten Eingang (85) umlaufenden elektrischen Strom identisch ist, und

ein viertes Schaltungsmodul (90), das einen ersten (95) und einen zweiten (96) Ausgang aufweist, die jeweils mit der zweiten Hauptelektrode des zweiten Zwischentransistors (2) und mit der ersten Hauptelektrode des vierten Transistors (72) verbunden sind, und in einer solchen Art und Weise aufgebaut ist, dass ein über den zweiten Ausgang (96) umlaufender elektrischer Strom zu einem über den ersten Ausgang (95) umlaufenden elektrischen Strom identisch ist.

2. Schaltung nach Anspruch 1, wobei das dritte Schaltungsmodul (80) einen fünften (81) und einen sechsten (82) Transistor des zweiten Typs aufweist, und jeder eine erste und eine zweite Hauptelektrode und eine Steuerelektrode aufweist, wobei die ersten Hauptelektroden des fünften und sechsten Transistors jeweils mit der zweiten Anschlussklemmenspannung (6) über einen fünften (93) und einen im Wesentlichen identischen sechsten (94) Widerstand verbunden sind, wobei die jeweiligen Steuerelektroden des fünften (81) und sechsten (82) Transistors miteinander verbunden sind, wobei die Steuerelektrode des fünften Transistors ferner mit der zweiten Hauptelektrode des fünften Transistors verbunden ist, wobei die zweiten Hauptelektroden des fünften (81) und sechsten (82) Transistors jeweils die ersten (85) und zweiten (86) Eingänge des dritten Schaltungsmoduls (80) aufweisen.

3. Schaltung nach Anspruch 1 oder 2, wobei das vierte Schaltungsmodul (90) einen siebten (91) und einen achten (92) Transistor des ersten Typs aufweist, und jeder eine erste und eine zweite Hauptelektrode und eine Steuerelektrode aufweist, wobei die ersten Hauptelektroden des siebten und achten Transistors jeweils mit der ersten Anschlussklemmenspannung (5) über einen siebten (93) und einen im Wesentlichen identischen achten (94) Widerstand verbunden sind, wobei die jeweiligen Steuerelektroden des siebten (91) und achten (92) Transistors miteinander verbunden sind, wobei die Steuerelektrode des siebten Transistors ferner mit der zweiten Hauptelektrode des siebten Transistors verbunden ist, wobei die zweite Hauptelektrode des siebten (91) und achten (92) Transistors jeweils den ersten (95) und zweiten (96) Ausgang des vierten Schaltungsmoduls (90) aufweist.

4. Schaltung nach einem der vorstehenden Ansprüche, wobei zumindest bestimmte Transistoren der Schaltung Bipolartransistoren sind.

5. Schaltung nach einem der vorstehenden Ansprüche, wobei zumindest ein Transistor des dritten (80) oder vierten (90) Schaltungsmoduls eine Hauptleitungsrichtung aufweist, die im Wesentlichen senkrecht zu einer Oberfläche eines Substrats des Schaltungsmoduls ist.

6. Operationsverstärker mit einer Leistungsverstärkungsschaltung nach einem der Ansprüche 1 bis 5, wobei die Schaltung aus einer Leistungsausgangsstufe des Operationsverstärkers besteht.

FIG.1.
ART ANTÉRIEUR

FIG.2.

FIG.3a.

FIG.3b.

I$_{SOURCE}$ ( ampères )

0,06

(FIG.2.)

0,05

FIG.4a.

(FIG.1.)

0,04

V$_{oh}$

V$_{cc}^+$

0,03

0,02

0,01

0,5   1   1,5   2   2,5   3   V$_D$ (Volts)

I$_{SINK}$ (ampères)

-2,5   -2   -1,5   -1   -0,5   V$_D$ (Volts)

-0,01

-0,02

V$_{ol}$

FIG.4b.

-0,03

V$_{cc}^-$

(FIG.1.)

-0,04

(FIG.2.)

-0,05

-0,06

FIG.5.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5049653 A